# EUROPEAN PATENT APPLICATION

(11) **EP 0 540 240 A1**
(43) Date of publication of application: **05.05.1993**
(21) Application number: 92309621.8
(22) Date of filing: 21.10.1992
(51) Int. Cl.: H01L 21/3205, H01L 21/321

(54) **Method for forming a dielectric film of a capacitor in semiconductor device**

(30) Priority: 21.10.1991 JP 271623/91
(71) Applicant: NEC CORPORATION, Tokyo (JP)
(72) Inventor: Okamura, Kenji, Minato-ku, Tokyo (JP)
(74) Representative: Moir, Michael Christopher

(57) **Abstract**

A lower electrode composed of polysilicon is formed on a silicon oxide film formed on a semiconductor substrate. Then, the lower electrode is heated in a rapid heating apparatus under a reduced pressure, and thereafter, heated in a nitriding atmosphere, so that a nitride film is formed on a surface of the lower electrode. Furthermore, a silicon nitride film is formed by a CVD process. Thus, since the capacitor dielectric film can be thinned, a semiconductor device having a capacitor of a large capacitance can be obtained.

## Description

### Background of the Invention

### Field of the invention

The present invention relates to a method for manufacturing a semiconductor device, and more particularly to a method for forming a dielectric film of a capacitor assembled in a semiconductor device such as a dynamic random access memory.

### Description of related art

Recently, integration density of a dynamic random access memory (abbreviated to "DRAM") has been increased, and an occupying area per a unitary memory cell has correspondingly been decreased. On the other hand, considering a capacitance value itself in view of a soft error and others, the capacitance cannot be allowed to decrease less than a constant value, for example, 25 fF. As a result, in compliance with the decrease of the occupying area of the memory cell, it is necessary to thin a capacitor dielectric film. At present, the capacitor dielectric film has been composed of a composite film by thermally oxidizing a silicon nitride film so that the silicon nitride film has an oxide film at its surface. In the following, a prior art method for forming a silicon nitride film will be described.

Firstly, a silicon oxide film is formed on a semiconductor substrate, and thereafter, is patterned so as to form an opening. Then, a polysilicon film is formed and patterned so as to form a lower electrode. Thereafter, for formation of a capacitor dielectric film, a silicon nitride film is formed, and then, in order to decrease a leakage current, an oxide film having a thickness on the order of about 1.5nm is formed by means of a thermal oxidation of the silicon nitride.

The above mentioned silicon nitride film has been ordinarily formed by a low-pressure chemical vapor deposition process. However, since atmosphere has been entered at the time of introducing the semiconductor substrate into a furnace tube of a low-pressure chemical vapor deposition apparatus, a surface of the polysilicon lower electrode is oxidized, so that an oxide film is formed under the silicon nitride film. This oxide film has a thickness on the order of about 1.5nm. Thus, a dielectric layer of the capacitor consists of (1) the oxide film formed on the surface of the lower electrode under the silicon nitride film, (2) the silicon nitride film itself, and (3) the oxide film formed on the upper surface of the silicon nitride film under the upper electrode.

In a microminiaturized DRAM, the capacitor dielectric film has been required to have a thickness of about 5nm or less in term of silicon oxide equivalent thickness (a film thickness calculated from the capacitance value by assuming that all the capacitor dielectric film is formed of an silicon oxide). In the above mentioned first prior art capacitor dielectric film, however, the oxide film, which was formed on the surface of the polysilicon lower electrode under the silicon nitride film, has a low dielectric constant and a thickness of 1.5nm. In addition, the oxide film formed on the surface of the polysilicon lower electrode is deteriorative in an insulating characteristics in comparison with the oxide film formed on the upper surface of the silicon nitride by means of the thermal oxidation of the silicon nitride. As a result, a problem has been encountered in that the capacitance value is low, and a current characteristics is deteriorative. Form a different viewpoint it can be said that, in order to decrease a leakage current, it is sufficient if the silicon oxide film is formed on only one surface of the silicon nitride film.

In order to reduce this problem, it has been proposed to perform a rapid thermal nitridation prior to the silicon nitride film formation, so as to nitride the surface of the polysilicon lower electrode, so that no oxidation occurs in the low-pressure chemical vapor deposition apparatus.

However, even in this second prior art method using the rapid thermal nitridation, since the lower electrode surface is oxidized by moisture absorbed to the semiconductor substrate surface at an initial stage of the thermal-nitridation, a problem has been encountered in that a semiconductor device having a capacitor of a large capacitance cannot yet be obtained.

### Summary of the Invention

Accordingly, it is an object of the present invention to provide a method for forming a capacitor dielectric film, which has overcome the above mentioned defect of the conventional one.

Another object of the present invention is to provide a method for forming a capacitor dielectric film having a thinner oxide film equivalent thickness, which makes it possible to obtain a semiconductor device having a capacitor of a large capacitance.

The above and other objects of the present invention are achieved in accordance with the present invention by a method for forming an insulator film on an electrode composed of polysilicon, comprising the steps of forming a polysilicon electrode on a semiconductor substrate, rapidly heating the polysilicon electrode in a reduced pressure atmosphere, heating the polysilicon electrode in a nitriding atmosphere so as to form a thermally nitrided film on the polysilicon electrode, and depositing a silicon nitride film on the thermally nitrided film by means of a CVD process, whereby a silicon nitride layer composed of the thermally nitrided film and the CVD deposited silicon nitride film is formed on the polysilicon electrode, with no silicon oxide at a boundary between the silicon nitride layer and the polysilicon electrode.

According to another aspect of the present invention, there is provided a method for forming a capacitor dielectric film in a semiconductor device, comprising the steps of forming on a semiconductor substrate a lower electrode composed of polysilicon and constituting a lower electrode of a capacitor, rapidly heating the lower electrode in a reduced pressure atmosphere, heating the lower electrode in a nitriding atmosphere so as to form a thermally nitrided film on the lower electrode, depositing a silicon nitride film on the thermally nitrided film by means of a CVD process so that a silicon nitride dielectric layer composed of the thermally nitrided film and the CVD deposited silicon nitride film is formed on the polysilicon electrode, with no silicon oxide at a boundary between the silicon nitride dielectric layer and the polysilicon electrode, and forming an upper electrode on the silicon nitride dielectric layer.

Specifically, the rapidly heating and the thermal nitridation are performed by introducing the semiconductor substrate formed with the polysilicon electrode into a vacuum chamber of a rapid heating apparatus, evacuating the vacuum chamber, heating the vacuum chamber to a first predetermined temperature when the vacuum chamber reaches a predetermined degree of vacuum so that moisture absorbed in the polysilicon electrode is removed, introducing a nitriding gas into the vacuum chamber, and thermally nitriding a surface of the polysilicon electrode.

In one embodiment, after the vacuum chamber reaches the predetermined degree of vacuum, the vacuum chamber is maintained at the predetermined temperature for a first time of period, and thereafter, the heating is stopped, and after the nitriding gas has been introduced into the vacuum chamber, the vacuum chamber is heated to a second predetermined temperature, again.

In addition, after the nitriding gas has been introduced into the vacuum chamber, the vacuum chamber is maintained at the second predetermined temperature for a second time of period, and then, the heating is stopped. More specifically, the first and second predetermined temperature are about 800°C, and the predetermined degree of vacuum is not greater than 10⁻⁵ Torr. The first time of period is 10 seconds and the second time of period is 15 seconds.

In another embodiment, after the vacuum chamber reaches the predetermined degree of vacuum, the vacuum chamber is maintained at the predetermined temperature, and after the predetermined degree of vacuum is maintained for a first predetermined period of time, the nitriding gas has been introduced into the vacuum chamber.

In addition, after the nitride gas has been introduced into the vacuum chamber, when a second time of period has elapsed, the heating is stopped. More specifically, the predetermined temperature is about 800°C, and the predetermined degree of vacuum is not greater than 10⁻⁵ Torr. The first time of period is 20 seconds and the second time of period is 30 seconds.

The invention also provides a semiconductor device comprising a substrate, a polysilicon electrode thereon, and an insulating layer of silicon nitride formed directly on said polysilicon electrode with no silicon oxide at the boundary between the silicon nitride layer and the polysilicon electrode.

The above and other objects, features and advantages of the present invention will be apparent from the following description (by way of example only) of preferred embodiments of the invention with reference to the accompanying drawings.

### BRIEF DESCRIPTION OF THE DRAWINGS

Figures 1A and 1B are diagrammatic sectional views of a capacitor portion of the semiconductor chip for illustrating the first embodiment of the method in accordance with the present invention for forming a dielectric film of a capacitor assembled in a semiconductor device;
Figure 2 is a process diagram for illustrating the first embodiment of the method in accordance with the present invention for forming a dielectric film of a capacitor assembled in a semiconductor device;
Figure 3 is a diagrammatic sectional view of a rapid heating apparatus used for performing the first embodiment of the method in accordance with the present invention for forming a dielectric film of a capacitor assembled in a semiconductor device;
Figure 4 is a graph illustrating the relation between the deposited thickness of silicon nitride film and the oxide film equivalent thickness for illustrating the advantage of the present invention; and
Figure 5 is a process diagram for illustrating the second embodiment of the method in accordance with the present invention for forming a dielectric film of a capacitor assembled in a semiconductor device.

### Description of the Preferred embodiments

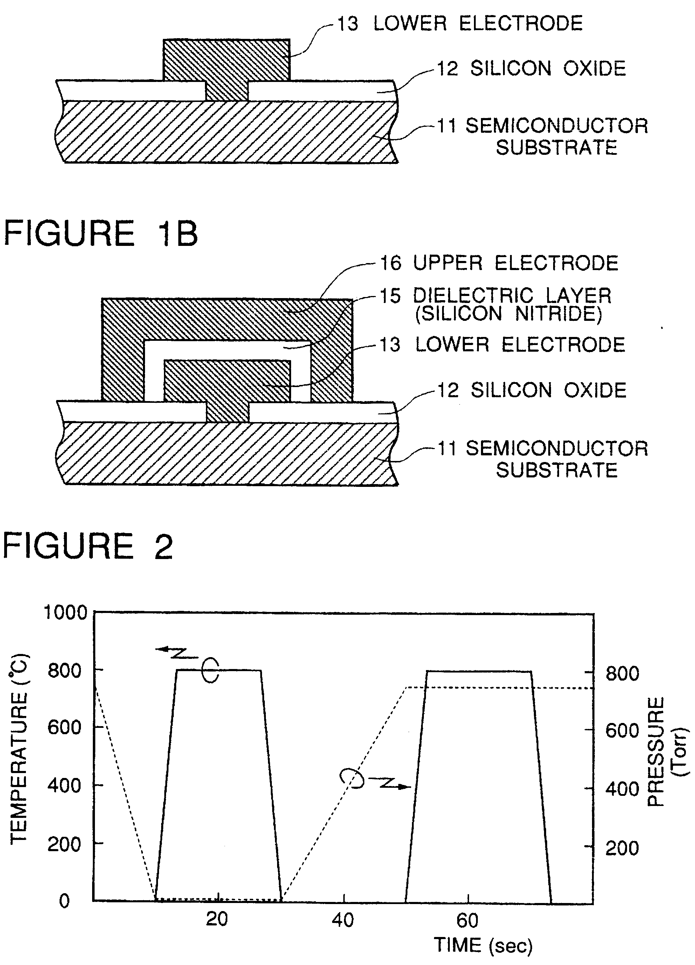

Now, the present invention will be described with reference to the drawings. Figures 1A and 1B are diagrammatic sectional views of a capacitor portion of the semiconductor chip for illustrating a first embodiment of the present invention.

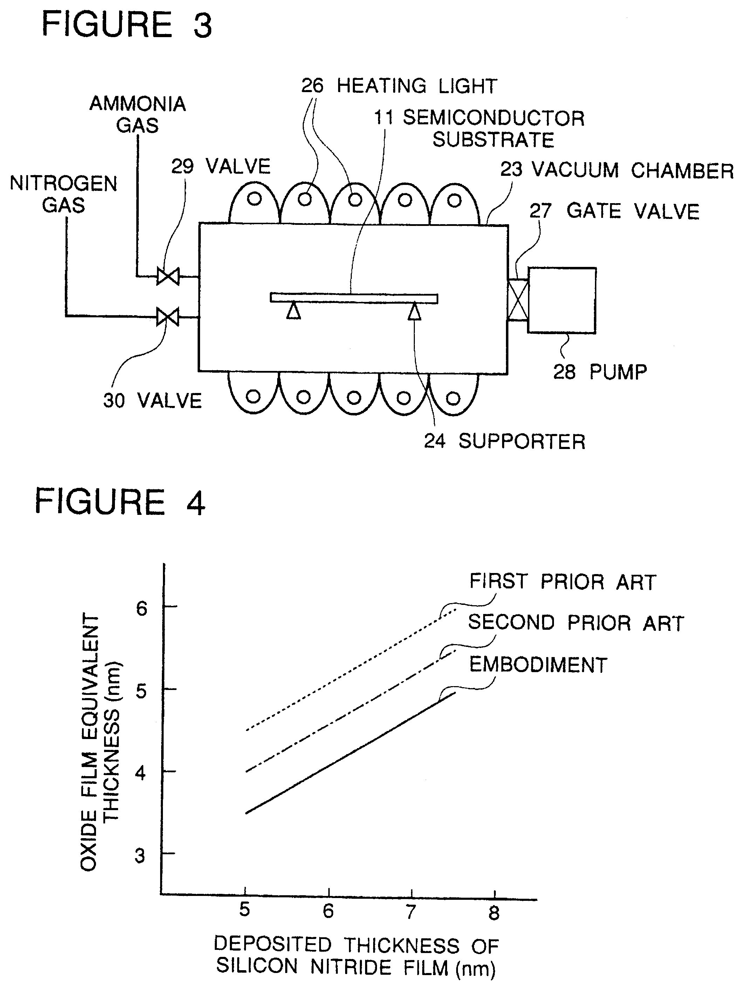

As shown in Figure 1A, a silicon oxide film 12 is formed on a semiconductor substrate 11, and thereafter, an opening is formed in the silicon oxide film 12. A lower electrode 13 composed of a polysilicon film is formed on the silicon oxide film 12 provided with the opening. Then, a thermal treatment is performed in a rapid thermal treatment apparatus for example as shown in Figure 3, prior to deposition of a silicon nitride film.

In Figure 3, Reference Numeral 23 designates a vacuum chamber, and Reference Numeral 24 shows a supporter for supporting a substrate to be subjected to a thermal treatment. Reference Numeral 11 indicates the semiconductor substrate supported on the supporter 24 in the vacuum chamber 23, and Reference Numeral 26 is a light source for heating the substrate 11 and an internal space of the vacuum chamber 23. In addition, Reference Numeral 27 designates a gate valve, and Reference Numeral 28 shows a vacuum pump. Reference Numeral 29 and 30 indicate valves. Figure 2 shows a change of the temperature and the pressure (degree of vacuum) in the thermal treatment process using the shown apparatus.

After the semiconductor substrate 11 is introduced in the vacuum chamber 23, the gate valve 27 is opened and the chamber 23 is evacuated by the pump 28. When the degree of vacuum becomes 10⁻⁵ Torr or less, the gate valve 27 is closed and the heating light sources 26 are powered on, so that the substrate 11 is heated at a temperature of 800°C for about 10 seconds. Thereafter, the heating light sources 26 are powered off, and the value 29 is opened so as to introduce ammonia gas into the chamber 23. When the pressure reaches the atmospheric pressure, the heating light sources 26 are powered on, again, so that the substrate is heated at a temperature of 800°C for about 15 seconds. Thus, a surface of the lower electrode 13 is thermally rapidly nitrided. In this process, since the moisture absorbed into the semiconductor substrate surface has been removed by previously heating the substrate in vacuum, the lower electrode surface is not oxidized at the time of the thermal nitridation, differently from the first prior art as mentioned hereinbefore.

Then, the gate valve 27 is opened so that the chamber 23 is evacuated by the pump 28. Thereafter, the gate valve 27 is closed and the value 30 is opened so as to introduce nitrogen gas into the chamber 23. After the pressure reaches the atmospheric pressure, the substrate 11 is taken out from the chamber 23, and moved to a low pressure chemical vapor deposition apparatus.

As shown in Figure 1B, a silicon nitride film 15 is deposited on the lower electrode 13 by use of a low pressure chemical vapor deposition process. Since the surface of the lower electrode 13 is already nitrided, there is no possibility that the surface of the lower electrode 13 is oxidized at the time of introducing the semiconductor substrate into the furnace tube of the low pressure chemical vapor deposition apparatus.

Referring to Figure 4, there is shown a graph illustrating the relation between the deposited thickness of silicon nitride film and the oxide film equivalent thickness. In Figure 4, the dotted line shows the first prior art as mentioned hereinbefore in which neither the rapid nitridation nor the rapid heating in vacuum is performed. The chain line indicates the second prior art as mentioned hereinbefore using the rapid thermal nitridation but no rapid heating in vacuum. The solid line shows the first embodiment as mentioned above.

It would be noted from Figure 4 that, according to the above mentioned embodiment, the oxide film equivalent thickness of the nitride film formed on the lower electrode 13 is remarkably reduced. This means at it is possible to realize a capacitor having a large capacitance. The oxide film equivalent thickness is further reduced by 0.5nm in comparison than the second prior art in which the rapid heating in vacuum is not performed.

Thereafter, in order to decrease a leakage current, the silicon nitride film 15 is thermally oxidized to as to form an oxide film having a thickness on the order of about 1.5nm on an upper surface of the silicon nitride film 15. Thus, a dielectric layer 15 is formed of the silicon nitride film deposited on the lower electrode 13 by use of the low pressure CVD and the silicon oxide film formed by thermally oxidizing the surface of the silicon nitride film. Then, an upper electrode 16 composed of polysilicon is formed to cover the dielectric layer 15. Thus, a capacitor is formed of the lower electrode 13, the dielectric layer 15 and the upper electrode 16.

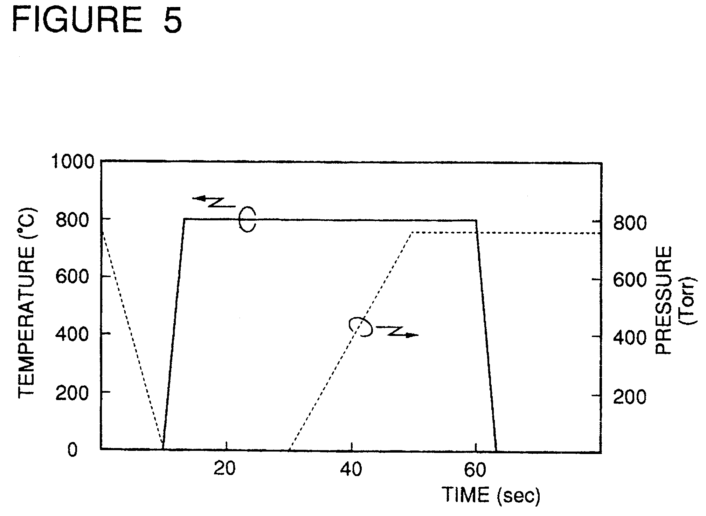

Figure 5 shows a process chart of a rapid heating for illustrating a second embodiment of the present invention. After the semiconductor substrate 11 is introduced in the vacuum chamber 23, the chamber is evacuated until the degree of vacuum becomes 10⁻⁵ Torr or less. Thereafter, the heating light sources 26 are powered on, so that the moisture of the substrate is removed at a temperature of 800°C. After 20 seconds, the value 29 is opened so as to introduce ammonia gas into the chamber 23. After 30 seconds, the heating light sources 26 are powered off. In this second embodiment, since the nitridation starts before the pressure of the ammonia gas in the vacuum chamber reaches the atmospheric pressure, the treatment time can be shortened.

As seen form the above, the present invention is featured in that, prior to deposition of the silicon nitride film forming a capacitor dielectric film of DRAMs, dehydration and nitridation under a reduced pressure is performed. This can prevent oxidation of the surface of the lower electrode formed of polysilicon for the capacitor. Therefore, a ultrathin dielectric film having the oxide film equivalent thickness on the order of 5nm can be obtained, and therefore, it is possible to obtain a semiconductor device having a capacitor of a large capacitance.

In the above mentioned embodiments, the silicon nitride film has been formed on the electrode composed of polysilicon, as a dielectric film of a capacitor. However, it would be apparent to persons skilled in the art that the silicon nitride film formed on the polysilicon in accordance with the present invention can be utilized to form an insulator film formed on a polysilicon electrode other than the capacitor electrode or a polysilicon wiring conductor.

The invention has thus been shown and described with reference to the specific embodiments. However, it should be noted that the present invention is in no way limited to the details of the illustrated structures but changes and modifications may be made within the scope of the appended claims.

## Claims

1. A method for forming an insulator film on an electrode composed of polysilicon, comprising the steps of forming a polysilicon electrode on a semiconductor substrate, rapidly heating said polysilicon electrode in reduced pressure atmosphere, heating said polysilicon electrode in a nitriding atmosphere so as to form a thermally nitrided film on said polysilicon electrode, and depositing a silicon nitride film on said thermally nitrided film by means of a CVD process, whereby a silicon nitride layer composed of said thermally nitrided film and said CVD deposited silicon nitride film is formed on said polysilicon electrode, with no silicon oxide at a boundary between said silicon nitride layer and said polysilicon electrode.

2. A method claimed in Claim 1 wherein said rapid heating and said thermal nitridation are performed by introducing said semiconductor substrate formed with said polysilicon electrode into a vacuum chamber of a rapid heating apparatus, evacuating said vacuum chamber, heating said vacuum chamber to a first predetermined temperature when said vacuum chamber reaches a predetermined degree of vacuum so that moisture absorbed in said polysilicon electrode is removed, introducing a nitriding gas into said vacuum chamber, and thermally nitriding a surface of said polysilicon electrode.

3. A method claimed in Claim 2 wherein after said vacuum chamber reaches said predetermined degree of vacuum, said vacuum chamber is maintained at said predetermined temperature for a first time of period, and thereafter, said heating is stopped, and after said nitriding gas has been introduced into said vacuum chamber, said vacuum chamber is heated to a second predetermined temperature, again.

4. A method claimed in Claim 3 wherein said first and second predetermined temperature are about 800°C, said predetermined degree of vacuum is not greater than 10⁻⁵ Torr, and said first time of period is 10 seconds

5. A method claimed in Claim 3 wherein after said nitriding gas has been introduced into said vacuum chamber, said vacuum chamber is maintained at said second predetermined temperature for a second time of period, and then, said heating is stopped.

6. A method claimed in Claim 5 wherein said first and second predetermined temperature are about 800°C, and said predetermined degree of vacuum is not greater than 10⁻⁵ Torr, and wherein said first time of period is 10 seconds and said second time of period is 15 seconds.

7. A method claimed in Claim 2 wherein after said vacuum chamber reaches said predetermined degree of vacuum, said vacuum chamber is maintained at said predetermined temperature, and after said predetermined degree of vacuum is maintained for a first predetermined period of time, said nitriding gas has been introduced into said vacuum chamber.

8. A method claimed in Claim 7 wherein said predetermined temperature is about 800°C, and said predetermined degree of vacuum is not greater than 10⁻⁵ Torr, and wherein said first time of period is 20 seconds.

9. A method claimed in Claim 8, wherein after said nitriding gas has been started to be introduced into said vacuum chamber, when a second time of period has elapsed, said heating is stopped.

10. A method claimed in Claim 9, wherein said predetermined temperature is about 800°C, and said predetermined degree of vacuum is not greater than 10⁻⁵ Torr, and wherein said first time of period is 20 seconds and said second time of period is 30 seconds.

11. A method as claimed in any preceding claim, wherein the silicon nitride layer is a capacitive dielectric layer, the polysilicon electrode constituting a first electrode of a capacitor, the method further comprising forming a second electrode on said silicon nitride layer.

12. A semiconductor device comprising a substrate, a polysilicon electrode thereon, and an insulating layer of silicon nitride formed directly on said polysilicon electrode with no silicon oxide at the boundary between the silicon nitride layer and the polysilicon electrode.
